# EUROPÄISCHE PATENTANMELDUNG

(11) **EP 1 401 104 A2**
(43) Veröffentlichungstag der Anmeldung: **24.03.2004**
(21) Anmeldenummer: 03102110.8
(22) Anmeldetag: 11.07.2003
(51) Int. Cl.: H03L 7/093

(54) **Schaltungsanordnung und Verfahren zum Abstimmen der Oszillationsfrequenz**

(30) Priorität: 19.09.2002 DE 10243504
(71) Anmelder: ROBERT BOSCH GMBH, 70442 Stuttgart (DE)
(72) Erfinder: Wermuth, Juergen, 31224, Peine (DE)

(57) **Zusammenfassung**

Um eine Schaltungsanordnung (100) sowie ein Verfahren zum Abstimmen der Oszillationsfrequenz in mindestens einer Empfangseinheit so weiterzuentwickeln, daß die in der Praxis gegebene Spannungsbegrenzung des Einschwingsignals für sehr schnell einschwingende P[hase]L[ocked]L[oop]-Empfangssysteme eliminiert bzw. kompensiert wird, wird vorgeschlagen, daß mindestens einem Phasenregelkreis, insbesondere mindestens einem P[hase]L[ocked]L[oop]-Regelkreis, mindestens eine Spannung-Zeit-Wandelschaltung zugeordnet wird, mittels derer mindestens ein oberhalb eines bestimmten Maximalspannungsschwellwerts (Uₘₐₓ) und/oder unterhalb eines bestimmten Minimalspannungsschwellwerts (Uₘᵢₙ) gelegener Spannungsbereich des Abstimmsignals in mindestens eine Impulsverlängerung des Abstimmsignals umgewandelt wird.

## Beschreibung

### Technisches Gebiet

Die vorliegende Erfindung betrifft eine zum Abstimmen der Oszillationsfrequenz in mindestens einer Empfangseinheit vorgesehene Schaltungsanordnung, aufweisend mindestens einen Phasenregelkreis, insbesondere mindestens einen P[hase]L[ocked]L[oop]-Regelkreis, mit mindestens einer Operationsverstärkereinheit.

Des weiteren betrifft die vorliegende Erfindung ein einer derartigen Schaltungsanordnung zugeordnetes Verfahren zum Abstimmen der Oszillationsfrequenz in mindestens einer Empfangseinheit.

Im speziellen bezieht sich die vorliegende Erfindung auf die P[hase]L[ocked]L[oop]-Problematik insbesondere bei F[requenz]M[odulation]-Empfängereinrichtungen, vor allem bei Anwendungen für Autoradios (--> schnelle A[Iternative]F[requency]-Tests).

### Stand der Technik

Rundfunkempfänger (auf A[mplituden]M[odulation]-Basis und/oder auf F[requenz]M[odulation]-Basis) bedienen sich heutzutage zur Frequenzabstimmung des Oszillators sogenannter P[hase]L[ocked]L[oop]-Systeme; dies bedeutet, daß in heutigen Empfängersystemen die Oszillationsfrequenz mittels eines Phasenregelkreises (= sogenanntes P[hase]L[ocked]L[oop]-System) eingestellt wird. In diesem Zusammenhang ist es gerade in Autoradioempfängern erforderlich, die momentane "Senderlandschaft" genau zu kennen, um im Bedarfsfalle, das heißt bei schlechtem Empfang automatisch und schnell einen Frequenzwechsel durchführen zu können.

Während des Empfangs sind also ständig andere Sender durch sogenannte A[Iternative]F[requency]-Tests auf Feldstärke, auf Güte und auf dergleichen zu kontrollieren. Um diese Vorgänge unhörbar zu machen, sind derartige Kontrollen so kurz wie möglich zu gestalten, wobei eine Dauer von etwa einer Millisekunde anzustreben ist; derzeit werden konventionellerweise etwa sieben Millisekunden - für "Mute", für Frequenzsprung, für Messung, für Rücksprung und für "Demute" - benötigt.

Der Frequenzsprung selbst dauert etwa ein bis zwei Millisekunden; dann ist das PLL-System, das heißt die phasenstarre bzw. phasenverriegelte Schleife eingeschwungen. Um ein PLL-System auf Schnelligkeit zu optimieren (sogenannter aperiodischer Grenzfall), ist es erforderlich, die möglichen Eckdaten des gesamten Regelkreises zu kennen und danach zu dimensionieren.

Zur richtigen Dimensionierung eines PLL-Systems haben die Abstimmsteilheit (vorzugsweise definiert in der Einheit Megahertz/Volt), die Einschwingzeit (vorzugsweise definiert in der Einheit Millisekunden) und der maximale Frequenzsprung (vorzugsweise definiert in der Einheit Megahertz) bekannt zu sein. Mit dem Pumpstrom des Phasenvergleichers, dessen Stromstärke typischerweise in der Größenordnung von etwa zwei Milliampere liegt, kann dann die Dimensionierung der Bauteile vorgenommen werden.

Die Funktionsweise eines derartigen PLL-Systems ist hierbei in vereinfachter Weise wie folgt: Die Spannung an einem Kondensator wird über einen Widerstand zu einer Kapazitätsdiode im Oszillatorschwingkreis weitergeleitet, um die Frequenz abzustimmen.

Des weiteren wird von einem konstanten Quarzoszillator, zum Beispiel mit einer Schwingungsfrequenz von vier Megahertz, durch digitale Frequenzteilung ein Referenztakt von 12,5 Kilohertz (oder auch von fünfzig Kilohertz) erzeugt. Ferner wird durch einen anderen vorgegebenen, veränderbaren digitalen Frequenzteiler die Frequenz des abgestimmten Oszillators auf 12,5 Kilohertz (oder auch auf fünfzig Kilohertz) geteilt.

In einem Phasenvergleicher werden die beiden geteilten Frequenzen verglichen:

Eilt der Oszillatortakt dem Referenztakt voraus, so fließt für die Zeit der Phasendifferenz ein konstanter Strom von zum Beispiel zwei Milliampere, der die Spannung am Kondensator entlädt und damit die Oszillationsfrequenz verringert.

Eilt der Oszillatortakt hingegen nach, so fließt der Strom in umgekehrter Richtung. Durch die vorgegebene Referenzfrequenz von 12,5 Kilohertz kommt es alle achtzig Mikrosekunden (bei fünfzig Kilohertz entsprechend alle zwanzig Mikrosekunden) zu einem Phasenvergleich mit entsprechend gerichtetem Stromfluß.

Ist nun das PLL-System richtig dimensioniert (Abstimmsteilheit, Kapazität und Strom), so schwingt das PLL-System ein, das heißt es gibt keine Phasendifferenz (<--> kein Stromfluß) und damit auch keine Frequenzdifferenz zwischen den geteilten Frequenzen. Soll nun eine andere Oszillationsfrequenz eingestellt werden, so ist der Frequenzteiler des abstimmbaren Oszillators zu verändern und der PLL-Regelkreis ist neu einzuschwingen. Dieser Vorgang funktioniert natürlich auch mittels Ändern des Referenzteilers oder mittels Ändern sowohl des Frequenzteilers als auch des Referenzteilers.

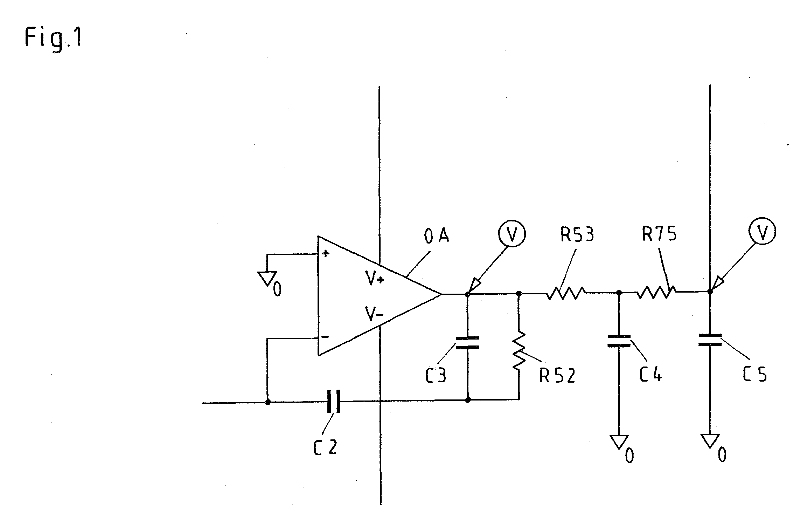

Um in der Praxis ein schnelles Einschwingen und gleichwohl ein sauberes "Halten" der neuen Frequenz zu erreichen, wird konventionellerweise anstelle des vorbeschriebenen Kondensators gemäß dem Stand der Technik ein sogenanntes "Schleifenfilter" eingesetzt. Ein derartiges PLL-Schleifenfilter aus dem Stand der Technik ist exemplarisch in Figur 1 dargestellt.

Der Kondensator C2 (mit einer Kapazität von zum Beispiel etwa 68 Nanofarad) aus Figur 1 entspricht in etwa dem vorbeschriebenen Kondensator und sorgt für die Stabilität im eingeschwungenen Zustand des PLL-Systems. Der Korrekturstrom des Phasenvergleichers setzt am negativen (= "-") Eingangsanschluß des Operationsverstärkers OA an.

Der Kondensator C3 (mit einer Kapazität von zum Beispiel etwa 4,7 Nanofarad) und der zu diesem Kondensator C3 parallel geschaltete Widerstand R52 (= zum Beispiel etwa 5,6 Kiloohm) sind für ein schnelleres Einschwingen bei größeren Frequenzänderungen (--> Phasenrand) vorgesehen.

Der Widerstand R53 (= zum Beispiel etwa zehn Kiloohm) und der diesem Widerstand R53 nachgeschaltete Kondensator C4 (mit einer Kapazität von zum Beispiel etwa einem Nanofarad) bilden ein sogenanntes "Nachfilter"; der dem Widerstand R53 nachgeschaltete Widerstand R75 (= zum Beispiel etwa 6,8 Kiloohm) verteilt die Abstimmspannung auf die Kapazitätsdioden (der Kondensator C5 (Kapazitätsdiode) hat zum Beispiel eine Kapazität von etwa 270 Picofarad).

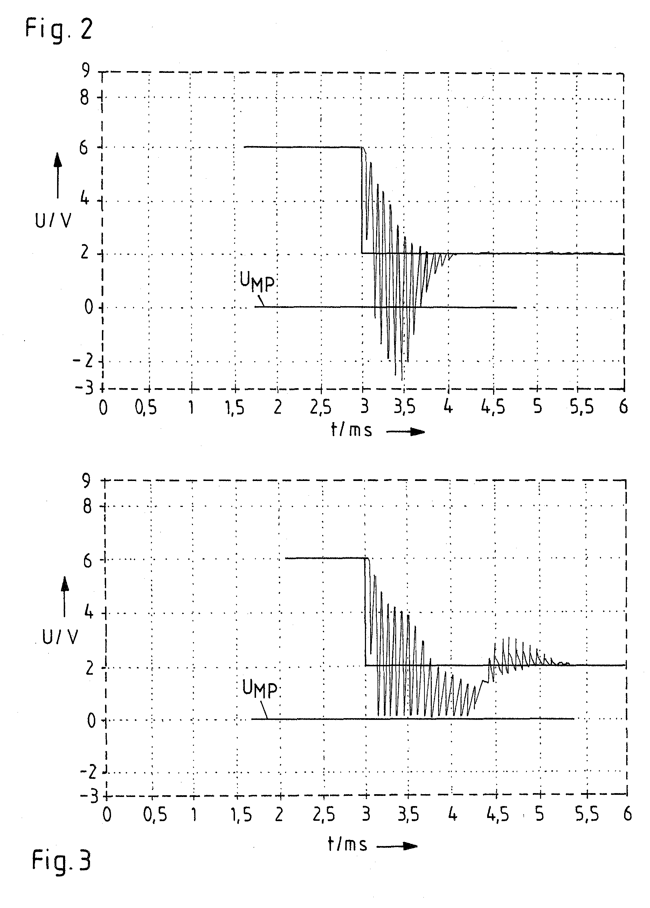

Das anhand Figur 1 veranschaulichte Schleifenfilter arbeitet in einer P[hase]L[ocked]L[oop] mit einem Referenztakt von etwa 12,5 Kilohertz und mit einem Pumpstrom von etwa zwei Milliampere. Dargestellt in Figur 2 ist ein Einschwingvorgang bei einem Frequenzsprung von 108 Megahertz auf 87,5 Megahertz Empfangsfrequenz.

In diesem Zusammenhang ist Figur 2 deutlich entnehmbar, daß Spannungsspitzen bis etwa -3 Volt erforderlich sind, und dies schon bei einer Einschwingzeit von etwa 1,5 Millisekunden; bei viel kürzeren Einschwingzeiten sind entsprechend noch erheblich größere Spannungen für das Einschwingsignal erforderlich.

Wird eine praktische Abstimmkennlinie vorausgesetzt (etwa sechs Volt für 108 Megahertz und etwa zwei Volt für 87,5 Megahertz), so bedeutet dies, daß dem Signal etwa drei Volt fehlen, weil die niedrigste Spannung in der Praxis null Volt (= Massepotential U_{MP}) ist.

Wird der gleiche Frequenzsprung mit einer der Praxis entsprechenden Spannungsbegrenzung und mit nichtlinearer Abstimmkennlinie, das heißt mit Abstimmverzerrung realisiert, so resultiert dies in einer Sprungantwort gemäß Figur 3. Es ist in Figur 3 deutlich zu erkennen, daß sich eine Verlängerung der Einschwingzeit auf etwa 2,5 Millisekunden ergibt, wobei der Einschwingvorgang nach diesem Zeitraum von 2,5 Millisekunden noch gar nicht vollständig beendet ist, sondern immer noch ein leichtes Überschwingen erfolgt.

Um nun die Spannungsbegrenzung der Abstimmspannung aufzuheben, müßte die Betriebsspannung des Operationsverstärkers vergrößert werden; eine derartige, an und für sich naheliegende Erhöhung des Betriebsspannungsbereichs versagt jedoch zumindest für den unteren Spannungswert, denn die Kapazitätsdioden würden zeitweise durch das Einschwingsignal leitend gesteuert.

### Darstellung der Erfindung: Aufgabe, Lösung, Vorteile

Ausgehend von den vorstehend dargelegten Nachteilen und Unzulänglichkeiten sowie unter Würdigung des umrissenen Standes der Technik liegt der vorliegenden Erfindung die Aufgabe zugrunde, eine Schaltungsanordnung sowie ein Verfahren der eingangs genannten Art so weiterzuentwickeln, daß die in der Praxis gegebene Spannungsbegrenzung des Einschwingsignals für sehr schnell einschwingende P[hase]L[ocked]L[oop]-Empfangssysteme eliminiert bzw. kompensiert wird.

Diese Aufgabe wird durch eine Schaltungsanordnung mit den im Anspruch 1 angegebenen Merkmalen sowie durch ein Verfahren mit den im Anspruch 9 angegebenen Merkmalen gelöst. Vorteilhafte Ausgestaltungen und zweckmäßige Weiterbildungen der vorliegenden Erfindung sind in den Unteransprüchen gekennzeichnet.

Mithin ist der Kern der vorliegenden Erfindung in der Bereitstellung eines schnellen Empfänger-P[hase]L[ocked]L[oop]-Einschwingbeschleunigers sowie eines entsprechend zugeordneten Verfahrens zum Abstimmen der Oszillationsfrequenz zu sehen; dies wird erfindungsgemäß dadurch erzielt, daß die in der Praxis gegebene Spannungsbegrenzung des Einschwingsignals für sehr schnelle PLL-Empfangssysteme durch eine entsprechende Schaltung eliminiert wird (eine naheliegende Erhöhung des Betriebsspannungsbereichs versagt, weil die Kapazitätsdioden zeitweise durch das Einschwingsignal leitend gesteuert würden).

Die Lösung gemäß der vorliegenden Erfindung liegt in der Umformung der Spannungshöhe des Einschwingsignals in eine Impulsverlängerung mittels mindestens einer in den Unteransprüchen gekennzeichneten Spannung-Zeit-Wandelschaltung, die dem mindestens einen an sich bekannten Phasenregelkreis zugeordnet wird. Mittels dieser Spannung-Zeit-Wandelschaltung wird mindestens ein oberhalb eines bestimmten Maximalspannungsschwellwerts (Uₘₐₓ) und/oder unterhalb eines bestimmten Minimalspannungsschwellwerts (Uₘᵢₙ) gelegener Spannungsbereich des Abstimmsignals in mindestens eine Impulsverlängerung des Abstimmsignals transformiert.

Diese Transformation des Signals erfolgt in vorteilhafter Weise unter weitgehender Beibehaltung der konstanten Ladung (= Pumpstrom I * Zeit t) im Schleifenfilter. Es wird gewissermaßen mittels der Spannung-Zeit-Wandelschaltung eine Umwandlung Spannung --> Zeit in bestimmten Signalbereichen, vorzugsweise oberhalb einer definierten maximalen Spannungsschwelle und/oder vorzugsweise unterhalb einer definierten minimalen Spannungsschwelle, durchgeführt.

Die vorliegende Erfindung betrifft schließlich die Verwendung mindestens einer Schaltungsanordnung gemäß der vorstehend dargelegten Art und/oder eines Verfahrens gemäß der vorstehend dargelegten Art in mindestens einem insbesondere fortbewegungsmittelgebundenen Rundfunkempfangsgerät, insbesondere in mindestens einem Autoradio, oder in mindestens einer Navigationseinrichtung.

### Kurze Beschreibung der Zeichnungen

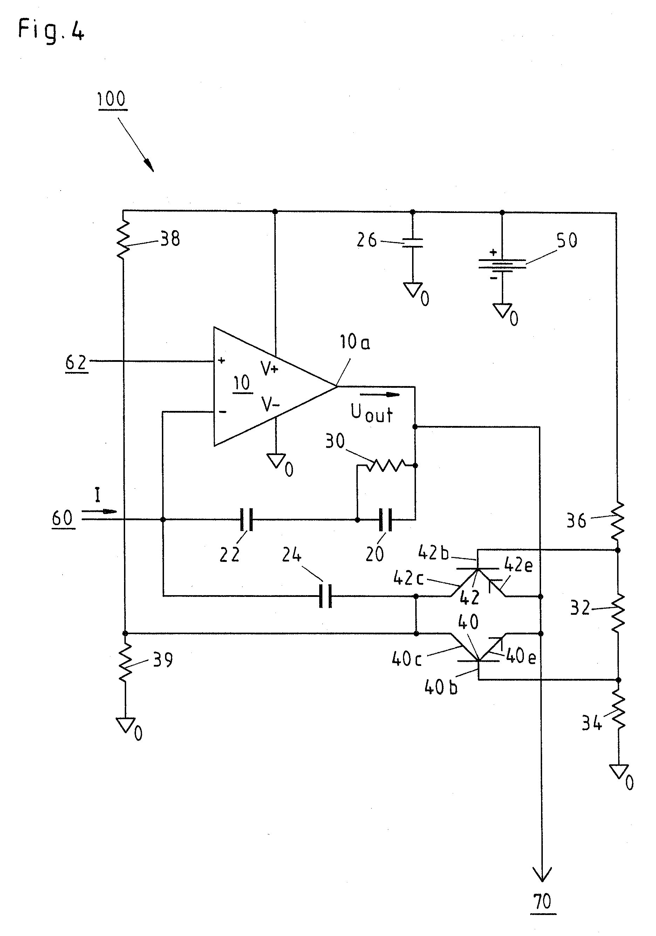

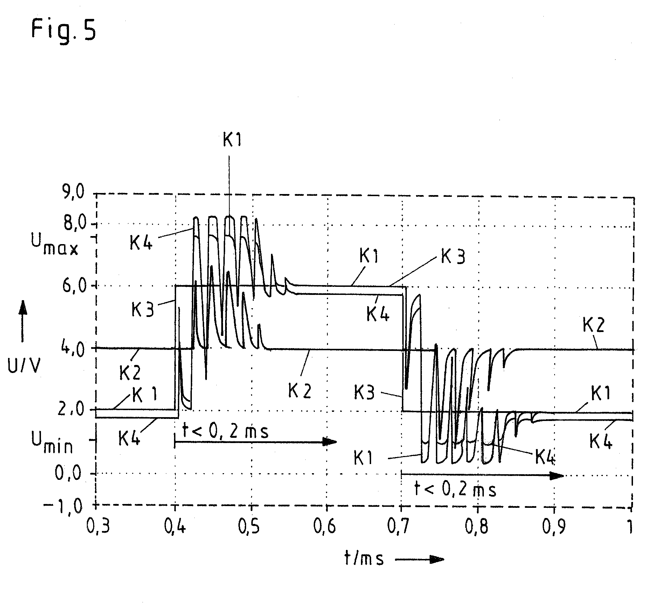

Wie bereits vorstehend erörtert, gibt es verschiedene Möglichkeiten, die Lehre der vorliegenden Erfindung in vorteilhafter Weise auszugestalten und weiterzubilden. Hierzu wird einerseits auf die den Ansprüchen 1 nachgeordneten Ansprüche verwiesen, andererseits werden weitere Ausgestaltungen, Merkmale und Vorteile der vorliegenden Erfindung nachstehend anhand des durch die Figuren 4 und 5 veranschaulichten Ausführungsbeispiels näher erläutert.

Es zeigt:
- Fig. 1: in schematischer Prinzipdarstellung ein Ausführungsbeispiel eines P[hase]L[ocked]L[oop]-Regelkreises aus dem Stand der Technik;
- Fig. 2: in schematischer Prinzipdarstellung ein Diagramm für einen ohne Spannungsbegrenzung und ohne nichtlineare Abstimmkennlinie, das heißt ohne Abstimmverzerrung erfolgenden Einschwingvorgang bei einem Frequenzsprung des P[hase]L[ocked]L[oop]-Regelkreises aus Fig. 1 von 108 Megahertz Empfangsfrequenz auf 87,5 Megahertz Empfangsfrequenz, wobei auf der Abszisse die Zeit in Millisekunden und auf der Ordinate die Spannung des Einschwingsignals in Volt aufgetragen ist;
- Fig. 3: in schematischer Prinzipdarstellung ein Diagramm für einen im Unterschied zu Figur 2 mit entsprechender Spannungsbegrenzung und mit nichtlinearer Abstimmkennlinie, das heißt mit Abstimmverzerrung erfolgenden Einschwingvorgang bei einem Frequenzsprung des P[hase]L[ocked]L[oop]-Regelkreises aus Fig. 1 von 108 Megahertz Empfangsfrequenz auf 87,5 Megahertz Empfangsfrequenz, wobei wiederum auf der Abszisse die Zeit in Millisekunden und auf der Ordinate die Spannung des Einschwingsignals in Volt aufgetragen ist;
- Fig. 4: in schematischer Prinzipdarstellung ein Ausführungsbeispiel einer Schaltungsanordnung gemäß der vorliegenden Erfindung; und
- Fig. 5: in schematischer Prinzipdarstellung ein Diagramm für einen Einschwingvorgang bei einem Frequenzsprung der Schaltungsanordnung aus Fig. 4 von 108 Megahertz Empfangsfrequenz auf 87,5 Megahertz Empfangsfrequenz, wobei auf der Abszisse die Zeit in Millisekunden und auf der Ordinate die Spannung des Einschwingsignals in Volt aufgetragen ist.

Gleiche oder ähnliche Ausgestaltungen, Elemente oder Merkmale sind in den Figuren 1 bis 5 mit identischen Bezugszeichen versehen.

### Bester Weg zur Ausführung der Erfindung

Das anhand Figur 4 veranschaulichte Ausführungsbeispiel einer beispielsweise im auf R[adio]D[aten]S[ystem]-Basis arbeitenden F[requenz]M[odulation]-Empfängersystem eines Autoradios integrierten Schaltungsanordnung 100 gemäß der vorliegenden Erfindung dient zum verfahrensmäßigen Abstimmen, Einstellen bzw. Steuern der Oszillatorfrequenz.

Auszugehen ist hierbei von einem P[hase]L[ocked]L[oop]-Regelkreis, das heißt von einem Schleifenfilter, das für ein PLL-System mit einem Referenztakt von etwa fünfzig Kilohertz, mit einem Pumpstrom von etwa ±2 Milliampere und mit linearisierter Abstimmkennlinie (Abstimmsteilheit = etwa 4,1 Megahertz/Volt ausgelegt ist.

Das Schleifenfilter ist hierbei in Figur 4 dadurch gegeben, daß dem Ausgangsanschluß 10o der Operationsverstärkereinheit 10 ein erstes kapazitives Element 20 (mit einer Kapazität von zum Beispiel etwa 360 Picofarad) nachgeschaltet ist, zu dem ein erstes Widerstandselement 30 (= zum Beispiel etwa 10,5 Kiloohm) parallel geschaltet ist.

Diesem ersten kapazitiven Element 20 ist ein zweites kapazitives Element 22 (mit einer Kapazität von zum Beispiel etwa 5,1 Nanofarad) nachgeschaltet, das sowohl mit dem Pumpstromeingang 60 für den Pumpstrom I (= zum Beispiel etwa ±2 Milliampere) als auch mit dem negativen Eingangsanschluß 10i1 der Operationsverstärkereinheit 10 verbunden ist.

Das Schleifenfilter weist einen Phasenrandwinkel von 61,5 Grad und eine Eigenfrequenz von 53.000/(2π) = 8.435 Hertz auf; wie bereits erwähnt, ist das Schleifenfilter für ein auf R[adio]D[aten]S[ystem]-Basis arbeitendes F[requenz]M[odulation]-Empfängersystem mit sehr schnellen Frequenzsprüngen vorgesehen. Wird nun dieses Schleifenfilter zum Gewährleisten dieser sehr schnellen Frequenzsprünge erfindungsgemäß mit einer Spannung-Zeit-Wandelschaltung (= sogenannter "U/t-Wandler") verknüpft, so ergibt sich die gesamte Schaltungsanordnung 100 gemäß Figur 4.

Das "Hinzufügen" des "U/t-Wandlers" gemäß der Lehre der vorliegenden Erfindung bedeutet, daß die (ursprüngliche) Schaltung des Schleifenfilters
- um ein drittes kapazitives Element 24
   (mit einer Kapazität von zum Beispiel etwa 1,2 Nanofarad),
- um einen zweiten Widerstand 32
   (= zum Beispiel etwa 6,8 Kiloohm),
- um einen dritten Widerstand 34
   (= zum Beispiel etwa 1,5 Kiloohm),
- um einen vierten Widerstand 36
   (= zum Beispiel etwa 1,5 Kiloohm),
- um einen fünften Widerstand 38
   (= zum Beispiel etwa zwei Kiloohm) und
- um einen sechsten Widerstand 39
   (= zum Beispiel etwa zwei Kiloohm) sowie
- um eine erste Transistoreinheit 40 und
- um eine zweite Transistoreinheit 42
erweitert wird.

Wie aus Figur 4 hervorgeht, sind der Operationsverstärkereinheit 10 die erste Transistoreinheit in Form der npn-Transistoreinheit 40 sowie die zweite Transistoreinheit in Form der pnp-Transistoreinheit 42 zugeordnet. Diese beiden Transistoreinheiten 40 bzw. 42 weisen jeweils einen Basisanschluß 40b bzw. 42b, einen Emitteranschluß 40e bzw. 42e sowie einen Kollektoranschluß 40c bzw. 42c auf und sind wie folgt verschaltet:

Der Basisanschluß 40b der ersten Transistoreinheit 40 ist mit dem Basisanschluß 42b der zweiten Transistoreinheit 42 über das zweite Widerstandselement 32 zusammengeschaltet; der Emitteranschluß 40e der ersten Transistoreinheit 40 sowie der Emitteranschluß 42e der zweiten Transistoreinheit 42 sind jeweils mit dem Ausgangsanschluß 10o der Operationsverstärkereinheit 10 verbunden.

Der Kollektoranschluß 42c der zweiten Transistoreinheit 42 ist mit dem Kollektoranschluß 40c der ersten Transistoreinheit 40 zusammengeschaltet und über das dritte kapazitive Element 24 sowohl mit dem Pumpstromeingang 60 als auch mit dem negativen Eingangsanschluß 10i1 der Operationsverstärkereinheit 10 als auch mit dem zweiten kapazitiven Element 22 verbunden.

Der Darstellung gemäß Figur 4 ist des weiteren entnehmbar, daß dem Basisanschluß 40b der ersten Transistoreinheit 40 das dritte Widerstandselement 34 zugeordnet ist. Der Basisanschluß 42b der zweiten Transistoreinheit 42 ist über das vierte Widerstandselement 36
- mit einer Gleichspannungsquelle 50 (= zum Beispiel etwa V = 8,5 Volt),
- mit einem vierten kapazitiven Element 26 (mit einer Kapazität von zum Beispiel etwa 47 Nanofarad), das im Grunde genommen dem ursprünglichen Schleifenfilter zuzurechnen ist,
- mit dem positiven Betriebsspannungseingang V+ der Operationsverstärkereinheit 10 sowie
- über das fünfte Widerstandselement 38 mit dem Kollektoranschluß 40c der ersten Transistoreinheit 40 sowie mit dem sechsten Widerstandselement 39
verbunden.

Durch das zweite Widerstandselement 32, das dritte Widerstandselement 34 und das vierte Widerstandselement 36 werden zwei Spannungsschwellen definiert, nämlich eine auf die erste Transistoreinheit 40 bezogene untere Spannungsschwelle bei etwa 1,3 Volt sowie eine auf die zweite Transistoreinheit 42 bezogene obere Spannungsschwelle bei etwa 7,2 Volt (--> Ub = 8,5 Volt). Diese Dimensionierung bewirkt folgendes:

Wird die Ausgangsspannung Uₒᵤₜ am Ausgangsanschluß 10o der Operationsverstärkereinheit 10 (sogenannter "rail-to-rail"-Typ) kleiner als ein Spannungswert von 1,3 Volt abzüglich einer Ub-Transistorspannungsschwelle von etwa 0,7 Volt, ist also die Ausgangsspannung Uₒᵤₜ kleiner als eine bestimmte untere Spannungsschwelle (= Minimalspannungsschwellwert Uₘᵢₙ) von 0,6 Volt, so fließt ein Kollektorstrom in der ersten Transistoreinheit 40 und sorgt für eine Begrenzung der Ausgangsspannung Uₒᵤₜ auf diesen Spannungswert Uₘᵢₙ = 0,6 Volt, was anhand der Kurve K1 in Figur 5 zu erkennen ist.

Gleichzeitig fließt ein Teil dieses Kollektorstroms der ersten Transistoreinheit 40, nämlich genau der Pumpstrom von ±2 Milliampere, über das dritte kapazitive Element 24 und lädt dieses auf, das heißt es erfolgt eine Speicherung der Ladung (= Pumpstrom I * Zeit t; vgl. Kurve K2 in Figur 5).

Wird der Pumpstrom durch den Phasenvergleicher der P[hase]L[ocked]L[oop] abgeschaltet, sorgt der nun fließende Entladestrom des dritten kapazitiven Elements 24 dafür, daß die Ausgangsspannung Uₒᵤₜ der Operationsverstärkereinheit 10 auf dem unteren Begrenzungswert Uₘᵢₙ = 0,6 Volt gehalten wird, bis die gespeicherte Ladung (= Pumpstrom I * Zeit t) des dritten kapazitiven Elements 24 aufgebraucht ist.

Es ergibt sich also anstelle einer weiteren Spannungsverringerung eine Impulsverlängerung. Der Entladestrom des dritten kapazitiven Elements 24 fließt einerseits über das fünfte Widerstandselement 38 sowie über das sechste Widerstandselement 39 und andererseits über das zweite kapazitive Element 22, über das erste kapazitive Element 20 sowie über das erste Widerstandselement 30, wobei die letzteren drei Elemente 20, 22 und 30 dem an sich bekannten Schleifenfilter zugeordnet werden können.

Steigt hingegen die Ausgangsspannung Uₒᵤₜ am Ausgangsanschluß 10o der Operationsverstärkereinheit 10 über einen Spannungswert von 7,2 Volt zuzüglich einer Ub-Transistorspannungsschwelle von etwa 0,7 Volt, ist also die Ausgangsspannung Uₒᵤₜ größer als eine bestimmte obere Spannungsschwelle (= Maximalspannungsschwellwert Uₘₐₓ) von 7,9 Volt, so fließt ein Kollektorstrom in der zweiten Transistoreinheit 42 und sorgt für eine Begrenzung der Ausgangsspannung Uₒᵤₜ auf diesen Spannungswert Uₘₐₓ = 7,9 Volt, was anhand der Kurve K1 in Figur 5 zu erkennen ist.

Gleichzeitig fließt ein Teil dieses Kollektorstroms der zweiten Transistoreinheit 42, nämlich genau der Pumpstrom von ±2 Milliampere, über das dritte kapazitive Element 24 und lädt dieses auf, das heißt es erfolgt eine Speicherung der Ladung (= Pumpstrom I * Zeit t; vgl. Kurve K2 in Figur 5).

Wird der Pumpstrom durch den Phasenvergleicher der P[hase]L[ocked]L[oop] abgeschaltet, sorgt der nun fließende Entladestrom des dritten kapazitiven Elements 24 dafür, daß die Ausgangsspannung Uₒᵤₜ der Operationsverstärkereinheit 10 auf dem oberen Begrenzungswert Uₘₐₓ = 7,9 Volt gehalten wird, bis die gespeicherte Ladung (= Pumpstrom I * Zeit t) des dritten kapazitiven Elements 24 aufgebraucht ist.

Es ergibt sich also wiederum anstelle einer weiteren Spannungserhöhung eine Impulsverlängerung. Der Entladestrom des dritten kapazitiven Elements 24 fließt einerseits über das fünfte Widerstandselement 38 sowie über das sechste Widerstandselement 39 und andererseits über das zweite kapazitive Element 22, über das erste kapazitive Element 20 sowie über das erste Widerstandselement 30.

Im Ergebnis wird also auch im Falle eines Ansteigens der Ausgangsspannung Uₒᵤₜ am Ausgangsanschluß 10o der Operationsverstärkereinheit 10 ebenfalls wieder die Ladung (= Pumpstrom I * Zeit t) im dritten kapazitiven Element 24 gespeichert (vgl. Kurve K2 in Figur 5), was nach Abschalten des Pumpstroms auch wieder zu einer entsprechenden Verlängerung des Impulses anstelle zu einem weiteren Spannungsanstieg führt.

In Figur 5 ist die Kurve K3 die Frequenzsprungvorgabe bei einer Abstimmsteilheit von etwa 4,1 Megahertz/Volt; die Kurve K4 entspricht der Signalspannung hinter mindestens einer für die Abstimmspannung bestimmten Kennlinien-Entzerreinrichtung 70, die der Schaltungsanordnung 100, und hierbei insbesondere dem Ausgangsanschluß 10o der Operationsverstärkereinheit 10, gemäß Figur 4 vorteilhafterweise nachgeschaltet werden kann bzw. sollte.

Die Wahl der Spannungsschwellwerte, das heißt des Maximalspannungsschwellwerts Uₘₐₓ und des Minimalspannungsschwellwerts Uₘᵢₙ, sollte im Hinblick auf die Abstimmkennlinie und auf die Betriebsspannung in sinnvoller Weise geschehen.

Der fünfte Widerstand 38 und der sechste Widerstand 39 bilden einen Spannungsteiler mit einem Innenwiderstand Ri von etwa einem Kiloohm und einem Spannungswert, der dem arithmetischen Mittelwert der beiden Spannungsschwellwerte Uₘₐₓ und Uₘᵢₙ entspricht, typischerweise also etwa einem arithmetischen Mittelwert von U = Ub/2 = 4,25 Volt.

Wie Figur 5 entnehmbar ist, können mittels der dem Phasenregelkreis erfindungsgemäß zugeordneten Spannung-Zeit-Wandelschaltung (= sogenannter "U/t-Wandler"), das heißt dadurch, daß die oberhalb eines bestimmten Maximalspannungsschwellwerts Uₘₐₓ bzw. unterhalb eines bestimmten Minimalspannungsschwellwerts Uₘᵢₙ gelegenen Spannungsbereiche des Abstimmsignals verfahrensgemäß in eine Impulsverlängerung des Abstimmsignals transformiert werden, Einschwingzeiten von weniger als 0,2 Millisekunden verwirklicht werden.

Dies stellt im Vergleich zum Stand der Technik eine beachtliche Verbesserung mit verhältnismäßig geringem Aufwand dar (unter gleichen Bedingungen sind konventionellerweise, das heißt ohne den vorbeschriebenen, als Spannung-Zeit-Wandelschaltung ausgebildeten "Einschwing-Beschleuniger" lediglich Einschwingzeiten von etwa zwei Millisekunden möglich). Die Dimensionierung der P[hase]L[ocked]L[oop] bzw. des Schleifenfilters ist die gleiche wie ohne "Einschwing-Beschleuniger", das heißt gemäß dem Stand der Technik.

Die vorliegende Erfindung ist durch PSpice-P[hase]L[ocked]L[oop]-Simulationen (--> Kapazitäten C sind mit Faktor 1.000 zu versehen; Zeiten t sind mit Faktor 1.000 zu versehen) und auch in F[requenz]M[odulation]-Empfängern gut nachweisbar. Praktischerweise kann die vorliegende, anhand des Ausführungsbeispiels der Figuren 4 und 5 veranschaulichte Erfindung in Autoradio-F[requenz]M[odulation]-Empfängern mit R[adio]D[aten]S[ystem] (A[lternative]F[requency]-Tests) eingesetzt bzw. direkt in P[hase]L[ocked]L[oop]-I[ntegrated]C[ircuit]s integriert werden.

## Patentansprüche

1. Zum Abstimmen der Oszillationsfrequenz in mindestens einer Empfangseinheit vorgesehene Schaltungsanordnung (100), aufweisend mindestens einen Phasenregelkreis, insbesondere mindestens einen P[hase]L[ocked]L[oop]-Regelkreis, mit mindestens einer Operationsverstärkereinheit (10),
**dadurch gekennzeichnet,**
**daß** dem Phasenregelkreis mindestens eine Spannung-Zeit-Wandelschaltung zugeordnet ist, mittels derer mindestens ein oberhalb eines bestimmten Maximalspannungsschwellwerts (Uₘₐₓ) und/oder unterhalb eines bestimmten Minimalspannungsschwellwerts (Uₘᵢₙ) gelegener Spannungsbereich des Abstimmsignals in mindestens eine Impulsverlängerung des Abstimmsignals transformierbar ist.

2. Schaltungsanordnung gemäß Anspruch 1, **dadurch gekennzeichnet, daß** beim Phasenregelkreis dem Ausgangsanschluß (10o) der Operationsverstärkereinheit (10) mindestens ein erstes kapazitives Element (20) nachgeschaltet ist, zu dem mindestens ein erstes Widerstandselement (30) parallel geschaltet ist.

3. Schaltungsanordnung gemäß Anspruch 2, **dadurch gekennzeichnet, daß** beim Phasenregelkreis dem ersten kapazitiven Element (20) mindestens ein zweites kapazitives Element (22) nachgeschaltet ist, das sowohl mit mindestens einem Pumpstromeingang (60) als auch mit dem negativen Eingangsanschluß (10i1) der Operationsverstärkereinheit (10) verbunden ist.

4. Schaltungsanordnung gemäß mindestens einem der Ansprüche 1 bis 3, **dadurch gekennzeichnet, daß** der Operationsverstärkereinheit (10)
- mindestens eine erste Transistoreinheit (40), insbesondere mindestens eine npn-Transistoreinheit, deren Emitteranschluß (40e) mit dem Ausgangsanschluß (10o) der Operationsverstärkereinheit (10) verbunden ist, sowie
- mindestens eine zweite Transistoreinheit (42), insbesondere mindestens eine pnp-Transistoreinheit, deren Emitteranschluß (42e) mit dem Ausgangsanschluß (10o) der Operationsverstärkereinheit (10) verbunden ist, zugeordnet sind.

5. Schaltungsanordnung gemäß Anspruch 4, **dadurch gekennzeichnet, daß** der Basisanschluß (40b) der ersten Transistoreinheit (40) mit dem Basisanschluß (42b) der zweiten Transistoreinheit (42) über mindestens ein zweites Widerstandselement (32) zusammengeschaltet ist.

6. Schaltungsanordnung gemäß Anspruch 4 oder 5, **dadurch gekennzeichnet, daß** der Kollektoranschluß (42c) der zweiten Transistoreinheit (42)
- mit dem Kollektoranschluß (40c) der ersten Transistoreinheit (40) zusammengeschaltet und
- über mindestens ein drittes kapazitives Element (24) sowohl mit dem Pumpstromeingang (60) als auch mit dem negativen Eingangsanschluß (10i1) der Operationsverstärkereinheit (10) als auch mit dem zweiten kapazitiven Element (22) verbunden ist.

7. Schaltungsanordnung gemäß mindestens einem der Ansprüche 4 bis 6, **dadurch gekennzeichnet,**
- **daß** dem Basisanschluß (40b) der ersten Transistoreinheit (40) mindestens ein drittes Widerstandselement (34) zugeordnet ist und
- **daß** der Basisanschluß (42b) der zweiten Transistoreinheit (42)
-- über mindestens ein viertes Widerstandselement (36)
-- mit mindestens einer Gleichspannungsquelle (50),
--- mit mindestens einem vierten kapazitiven Element (26),
--- mit dem positiven Betriebsspannungseingang (V+) der Operationsverstärkereinheit (10) sowie
--- über mindestens ein fünftes Widerstandselement (38) mit dem Kollektoranschluß (40c) der ersten Transistoreinheit (40) sowie mit mindestens einem sechsten Widerstandselement (39) verbunden ist.

8. Schaltungsanordnung gemäß mindestens einem der Ansprüche 1 bis 7, **dadurch gekennzeichnet, daß** dem Ausgangsanschluß (10o) der Operationsverstärkereinheit (10) mindestens eine Entzerreinrichtung (70), insbesondere mindestens eine Kennlinien-Entzerreinrichtung, zum Entzerren der Kennlinie des Abstimmsignals nachgeschaltet ist.

9. Verfahren zum Abstimmen der Oszillationsfrequenz in mindestens einer Empfangseinheit,
**dadurch gekennzeichnet,**
**daß** mindestens einem Phasenregelkreis, insbesondere mindestens einem P[hase]L[ocked]L[oop]-Regelkreis, mindestens eine Spannung-Zeit-Wandelschaltung zugeordnet wird, mittels derer mindestens ein oberhalb eines bestimmten Maximalspannungsschwellwerts (Uₘₐₓ) und/oder unterhalb eines bestimmten Minimalspannungsschwellwerts (Uₘᵢₙ) gelegener Spannungsbereich des Abstimmsignals in mindestens eine Impulsverlängerung des Abstimmsignals umgewandelt wird.

10. Verwendung mindestens einer Schaltungsanordnung (100) gemäß mindestens einem der Ansprüche 1 bis 8 und/oder eines Verfahrens gemäß Anspruch 9 in mindestens einem insbesondere fortbewegungsmittelgebundenen Rundfunkempfangsgerät, insbesondere in mindestens einem Autoradio, oder in mindestens einer Navigationseinrichtung.
